# FASCICULE DE BREVET EUROPEEN

(11) **EP 3 327 747 B1**
(45) Date de publication et mention de la délivrance du brevet: **14.08.2019**
(21) Numéro de dépôt: 17195386.2
(22) Date de dépôt: 09.10.2017
(51) Int. Cl.: H01H 83/04, H01H 83/20

(54) **APPAREIL DE PROTECTION ÉLECTRIQUE À BOUTON TEST**
ELEKTRISCHER SCHUTZSCHALTER MIT PRÜFTASTE
ELECTRICAL PROTECTION APPARATUS WITH TEST BUTTON

(30) Priorité: 28.11.2016 FR 1661556
(43) Date de publication de la demande: 30.05.2018
(73) Titulaire: Schneider Electric Industries SAS, 92500 Rueil-Malmaison (FR)
(72) Inventeur: BERNARD, Jean-Baptiste, 38050 Grenoble (FR)
(74) Mandataire: Colette, Marie-Françoise

(56) Documents cités:
- US-A1- 2004 252 425
- US-A1- 2008 204 947

## Description

### DOMAINE TECHNIQUE

La présente invention concerne un appareil de protection électrique comportant au moins une fonction électrique de protection dite première ou principale apte à être réalisée par un microcontrôleur et un bouton dit bouton test destiné à être actionné par un utilisateur pour entraîner la mise en oeuvre du test d'au moins une fonction électrique dite seconde, cette mise en oeuvre du test étant destinée à entraîner le déclenchement de l'appareil de protection.

### ETAT DE LA TECHNIQUE ANTERIEURE

On connaît des appareils de protection électriques communément appelés disjoncteurs AFDD comportant un module disjoncteur associé à un module logeant la fonction de détection des arcs électriques qui peuvent se produire dans des conducteurs ou connexions défectueuses et sont susceptibles de produire une chaleur locale importante (Fonction AFDD). Certains de ces disjoncteurs AFDD intègrent également la fonction de protection différentielle.

Ces appareils disposent en face avant d'un bouton dit bouton test, permettant lors de son appui de lancer un test de la fonction détection d'arc ou de la fonction différentielle de l'appareil. Si le test est concluant, un déclenchement de l'appareil est réalisé.

Grâce à la manette de déclenchement située en face avant de l'appareil de protection, il est possible de distinguer, si un déclenchement provient du disjoncteur ou bien du module AFDD. Lorsqu'un déclenchement provient du disjoncteur, la manette précitée est en position déclenchée et un indicateur visible à travers une fenêtre de visualisation du module AFDD indique une position non déclenchée de l'appareil. Au contraire, lorsqu'il s'agit d'un déclenchement du au module AFDD, la manette ainsi que l'indicateur indiquent une position déclenchée.

Dans le cas de l'intégration d'une protection différentielle dans le module AFDD existant, il n'est pas possible de différencier une cause de déclenchement RCD (c'est-à-dire généré par la fonction de protection différentielle) d'une cause de déclenchement AFDD suite à une détection d'arc, car les deux fonctions sont réalisées dans le même bloc de 18mm. Ainsi, sur les appareils AFDD actuels, afin de récupérer l'information précise de la cause de déclenchement, il convient de démonter l'appareil du tableau, et de l'insérer sur un support dédié permettant d'établir la communication avec un ordinateur.

Or, lors de l'intégration de plusieurs fonctions de protection dans un même module, il est primordial de pouvoir définir de façon simple le type de défaut ayant généré le déclenchement de l'appareil afin de pouvoir lancer une investigation rapide de la cause de déclenchement, et donc procéder à sa correction dans l'installation électrique.

Cette remontée d'informations doit être simple pour l'utilisateur amené à utiliser l'appareil (installateur électricien, voir client particulier).

On connaît le document US 2008/204947 décrivant un appareil de protection électrique comportant un bouton test.

### EXPOSE DE L'INVENTION

La présente invention résout ces problèmes et propose un appareil de protection électrique équipé d'un bouton test et d'une intelligence de décodage (microcontrôleur) permettant d'ajouter de façon simple une fonction sur demande ayant une valeur ajoutée pour l'utilisateur, telle que la fonction de communication de la dernière cause de déclenchement de l'appareil.

A cet effet, la présente invention a pour objet un appareil de protection électrique du genre précédemment mentionné, cet appareil comportant des moyens pour mutualiser l'actionnement de ce bouton test avec au moins une action destinée à réaliser une fonction dite troisième, en fonction de différents types d'action exercées sur le bouton test, ces actions étant détectées par le microcontrôleur dans le but pour ce dernier de donner l'ordre de réaliser l'une des fonctions dites troisièmes précitées ou bien le test de l'une des fonctions dites secondes précitées.

Selon une caractéristique particulière, la fonction électrique dite première ou principale comprend la fonction de détection d'un court-circuit ou bien la fonction de détection d'une surcharge électrique.

Selon une autre caractéristique, la au moins une fonction dite seconde est l'une des fonctions comprises dans le groupe comprenant une fonction de protection différentielle, une fonction de détection d'arc, ou une fonction de détection d'un défaut différentiel sur courant continu, par exemple une fonction RCD Type B.

Selon une autre caractéristique, la au moins une fonction dite troisième est une action de transmission d'information de la dernière cause du déclenchement de l'appareil stockée par le microcontrôleur.

Selon une autre réalisation, l'appareil comportant la fonction protection différentielle, l'information précitée est la valeur du courant de fuite à la terre vu par la protection différentielle.

Selon une autre caractéristique, les moyens de transmission de l'information précitée, dits premiers, comportent une LED dite première, ou bien une liaison sans fil.

Selon une autre caractéristique, la LED précitée est apte à émettre un signal lumineux codé dont le code correspond au type d'information à transmettre.

Selon une autre caractéristique, la dernière cause du déclenchement est l'une des causes comprises dans le groupe comprenant la détection d'un défaut différentiel, la détection d'un arc série, la détection d'un arc parallèle, la détection d'un défaut du à une surtension ou d'un défaut d'origine interne à l'appareil. Ce défaut d'origine interne peut ainsi consister en une défaillance de l'unité de calcul du microcontrôleur ou une corruption de la mémoire Flash.

Selon une autre caractéristique, les différents types d'action sur le bouton test comprennent un appui long et/ou un appui court et/ou un double appui court, et/ou un nombre donné, ou une combinaison, des séquences précédentes dans une fenêtre temporelle donnée. Par exemple, quatre double appuis en moins de vingt secondes.

Selon une autre caractéristique, l'actionnement du bouton test par un appui long a pour effet l'envoi par le microcontrôleur d'un ordre de réalisation du test de l'une des fonctions dites secondes pendant un temps calibré, tandis que l'actionnement du bouton test par un double appui court a pour effet la réalisation d'au moins l'une des fonctions dites troisièmes précitées. Le fait d'envoyer cet ordre pendant un temps calibré permet de ne pas stresser inutilement les composants électroniques rentrant en jeu dans la fonction.

Selon une autre caractéristique, l'actionnement du bouton test par un nombre donné de doubles appuis courts dans une fenêtre temporelle donnée envoie une séquence de RESET de la mémoire interne.

Selon une caractéristique particulière, cet appareil comporte des moyens d'information de l'utilisateur, dits seconds, du type d'action exercée sur le bouton test détectée par le microcontrôleur, et des moyens d'acquittement par l'utilisateur de l'action demandée au moyen d'un nouvel actionnement du bouton test.

Selon une caractéristique particulière, les moyens d'information dits seconds comportent une LED dite seconde apte à clignoter après l'actionnement du bouton test pendant une durée prédéterminée suivant deux clignotements différents en fonction de ce que le microcontrôleur a détecté, ce clignotement étant apte à être interrompu pendant cette durée lorsque l'utilisateur actionne les moyens d'acquittement précités.

Selon une caractéristique particulière, la LED dite première et/ou la LED dite seconde est/sont située(s) sur la face avant de l'appareil.

Selon une caractéristique particulière, cet appareil est un disjoncteur différentiel comportant la fonction de détection d'arc.

Selon une autre caractéristique, cet appareil comporte un module disjoncteur associé à un module de protection différentielle intégrant la fonction de détection d'arc.

### BREF DESCRIPTIF DES FIGURES

Mais d'autres avantages et caractéristiques de l'invention apparaîtront mieux dans la description détaillée qui suit et se réfère aux dessins annexés donnés uniquement à titre d'exemple et dans lesquels :
- La figure 1 est une vue en perspective d'un disjoncteur différentiel AFDD-RCD selon une réalisation particulière de l'invention,
- La figure 2 est un schéma électrique illustrant l'établissement de la connexion selon l'invention entre d'une part, le microcontrôleur du disjoncteur ou le module AFDD associé latéralement à celui-ci, et d'autre part, le bouton test,
- La figure 3 est un diagramme illustrant le fonctionnement d'un disjoncteur selon une réalisation particulière de l'invention,

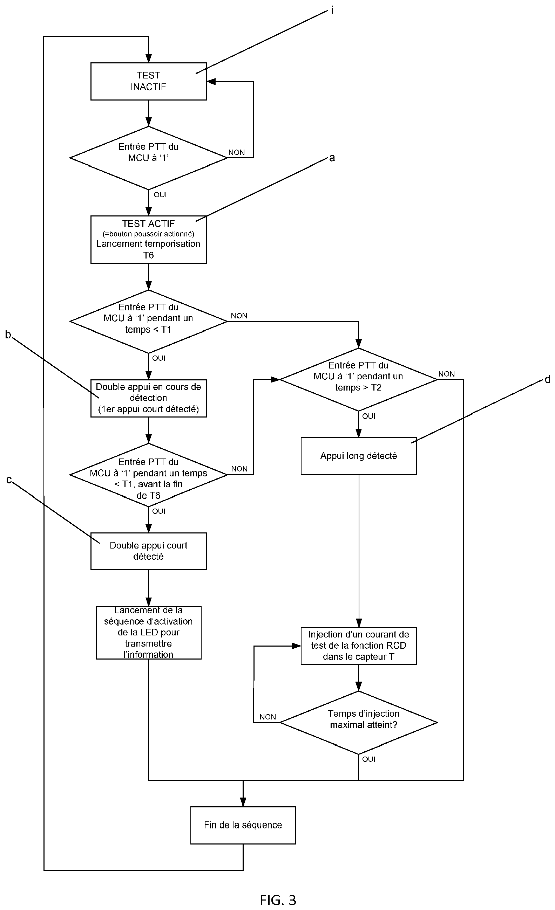

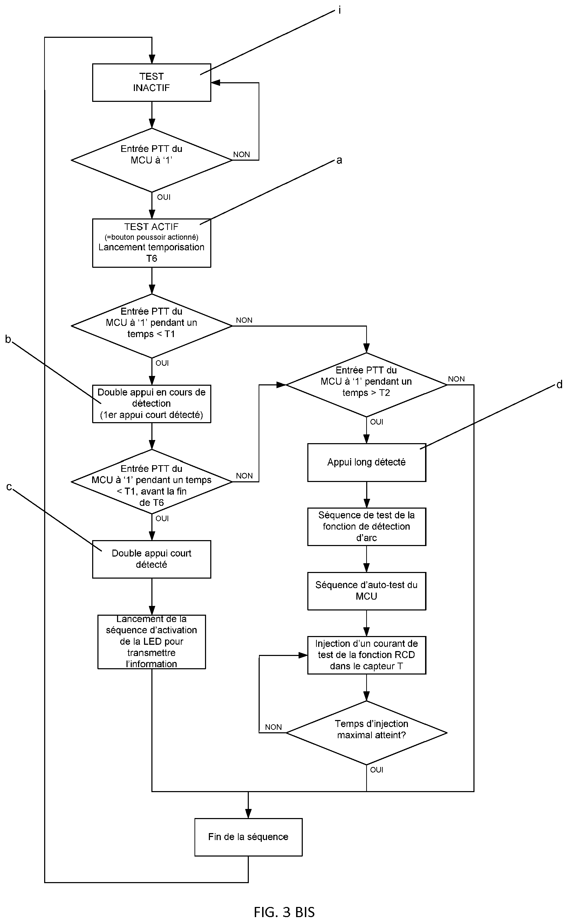

- La figure 3bis est un diagramme illustrant le fonctionnement d'un disjoncteur selon un autre mode de réalisation de l'invention présentant une couverture de test plus importante,

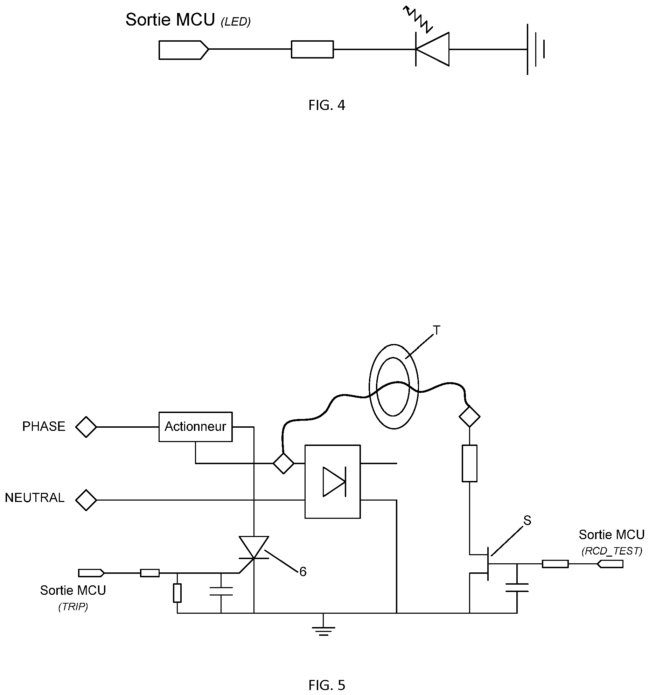

- La figure 4 est un schéma électrique illustrant le pilotage d'une LED par le microcontrôleur lors de la détection de deux appuis courts sur le bouton test par le microcontrôleur,
- La figure 5 est un schéma électrique illustrant un test de la protection différentielle, lors de la détection d'un appui long sur le bouton test par le microcontrôleur, et

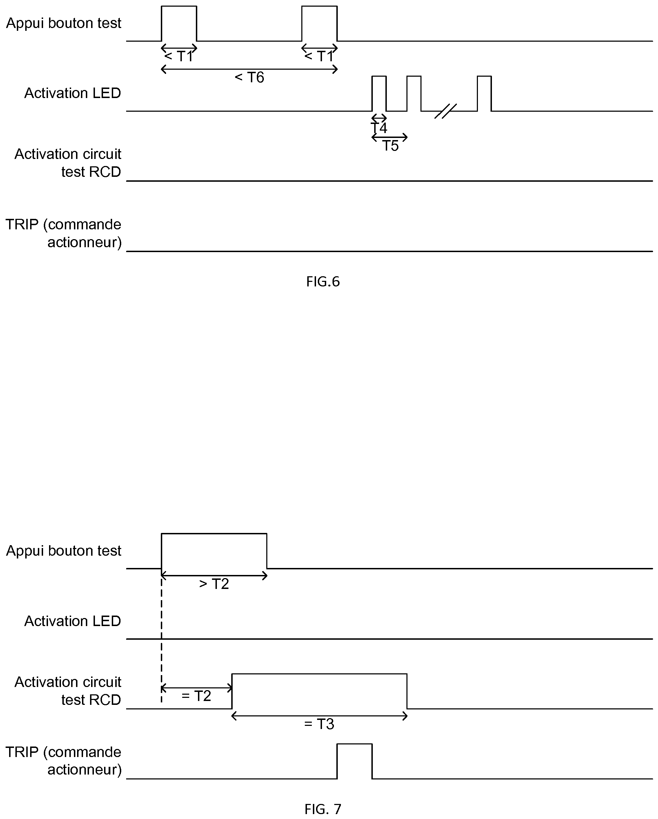

- Les figures 6 à 9 sont des chronogrammes illustrant le fonctionnement d'un disjoncteur AFDD-RCD en fonction de différents types d'actionnement du bouton test.

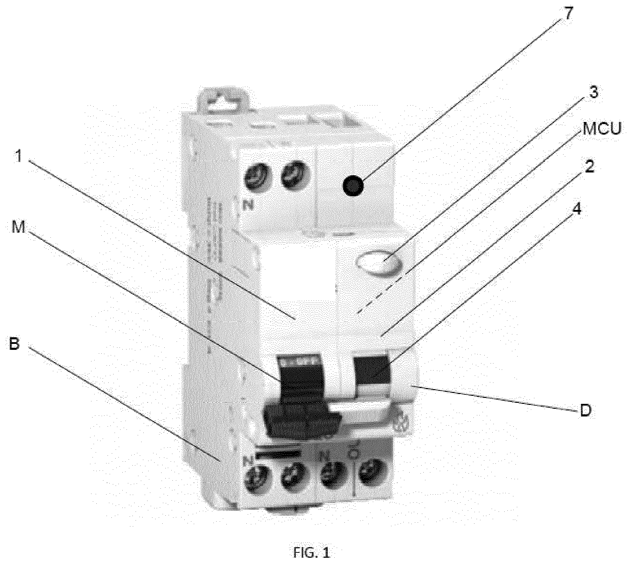

Sur la figure 1, on voit un disjoncteur différentiel D dit AFDD-RCD selon une réalisation particulière de l'invention, ledit appareil comportant un module disjoncteur 1 associé à un module 2 dit AFDD-RCD. On notera que dans ce qui suit, l'ajout du terme « AFDD » signifie que l'appareil comporte la fonction dite « détection des arcs », tandis que l'ajout de l'appellation « RCD » signifie que l'appareil réalise la fonction « protection différentielle ». De manière connue en soi, le module disjoncteur 1 réalise la fonction principale, dite première, de protection électrique lors de l'apparition d'un court-circuit ou bien d'une surcharge électrique dans le circuit à protéger, tandis que le module dit AFDD-RCD 2 réalise la fonction, dite seconde, de protection électrique en cas d'apparition d'arcs électriques susceptibles de se produire dans des conducteurs ou connexions défectueuses, ainsi que celle de protection différentielle. La fonction principale précitée est réalisée par l'intermédiaire d'un microcontrôleur MCU coopérant avec des moyens de détection des défauts précités de manière à réaliser l'ouverture des contacts précités.

Ces deux modules 1,2 sont logés dans un boîtier monobloc B ou constitué par l'association de deux boîtiers correspondant respectivement aux deux modules MCB et AFD, l'ensemble comportant sur sa face avant un bouton poussoir 3, dit bouton test, lequel étant destiné à être actionné dans le but de lancer une séquence de test de la fonction détection d'arc ou bien de la fonction différentielle, ou bien des deux fonctions.

Ce disjoncteur D comporte sur sa face avant une manette M apte à être déplacée entre une position fermée des contacts du disjoncteur D et une position ouverte desdits contacts, le passage d'une position à l'autre pouvant être réalisée soit manuellement par un utilisateur, soit automatiquement lors de la survenue d'un défaut électrique dans le circuit à protéger. Le module dit AFDD-RCD 2 présente sur sa face avant une fenêtre de visualisation 4 apte à laisser apparaître un support coloré en fonction de l'état déclenché ou non du module AFDD-RCD.

Selon l'invention, cet appareil comporte des moyens pour mutualiser l'actionnement de ce bouton test 3 avec au moins une action destinée à réaliser une fonction dite troisième, en fonction de différents types d'action exercées sur le bouton test, ces actions étant détectées par le microcontrôleur MCU dans le but pour ce dernier de donner l'ordre de réaliser l'une des fonctions dites troisièmes précitées ou bien le test de l'une des fonctions dites secondes précitées.

Ainsi, selon l'invention, le microcontrôleur utilisé pour réaliser la fonction de protection dite principale est utilisé pour détecter différents types d'action sur le bouton poussoir tel qu'un appui long, un appui court, ou un double appui court, ou un nombre donné de double appuis courts ou bien un nombre donné de ces séquences ou une combinaison donnée des séquences précédentes, dans une fenêtre temporelle donnée afin de lancer une action particulière.

Selon une réalisation particulière, l'actionnement du bouton test 3 (ou PTT) par un appui long a pour effet l'envoi par le microcontrôleur MCU d'un ordre de réalisation du test de l'une des fonctions dites secondes, tandis que l'actionnement du bouton test 3 par un double appui court a pour effet la réalisation d'au moins l'une des fonctions dites troisièmes précitées.

Selon une réalisation particulière de l'invention, la fonction dite seconde est une fonction de protection différentielle tandis que la fonction dite troisième est la fonction de communication de l'information de la dernière cause de déclenchement de l'appareil.

Ainsi, lors de l'actionnement du bouton test par un double appui rapide, une transmission de la dernière cause de déclenchement stockée par le microcontrôleur est transmise à l'utilisateur via une LED 7 dont le nombre de clignotement est représentatif de la dernière cause de déclenchement de l'appareil. Et, lors d'un appui long sur le bouton test, une séquence de test RCD est envoyée, consistant à générer un courant différentiel dans le tore sommateur du dispositif de détection d'un défaut différentiel appartenant au module AFDD RCD.

Ainsi, dans cette réalisation, il n'est pas utile de rajouter un second bouton afin d'obtenir cette information de la dernière cause de déclenchement, d'où une réduction de coût et d'encombrement. Pour un coût équivalent, on rajoute donc une fonctionnalité ayant une forte valeur ajoutée pour l'utilisateur afin d'investiguer le défaut et déterminer la cause exacte du déclenchement.

Ainsi, sur des produits de faible encombrement et sans remettre en cause toute la conception du produit, l'invention permet d'utiliser et d'adapter les fonctionnalités mises en place, à savoir le bouton poussoir 3 connecté au microcontrôleur MCU, afin d'ajouter une fonctionnalité à forte valeur ajoutée pour l'utilisateur.

Le fonctionnement détaillé d'un appareil de protection électrique selon la réalisation précédemment décrite va être décrit dans ce qui suit en référence à la figure 3.

En position de service de l'appareil, le bouton poussoir est désactivé (i).

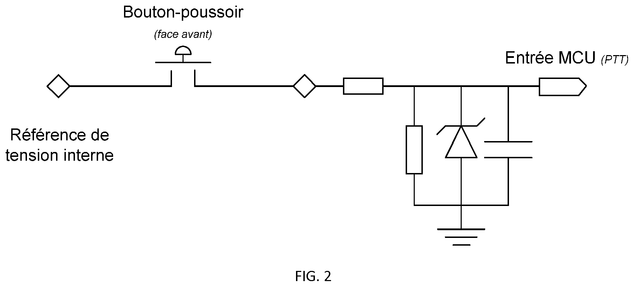

Lors d'une première activation en (a) du bouton poussoir PTT en face avant pendant une durée supérieure à 50ms, une connexion s'établit avec le microcontrôleur MCU permettant à celui-ci de savoir que le bouton poussoir est appuyé. L'appui sur ce bouton amène une tension logique haute (figure 2) sur l'entrée du microcontrôleur MCU.

Puis, une seconde action est réalisée sur le bouton poussoir.

Suivant le type d'actions exercées sur le bouton poussoir, la machine d'état embarquée dans le microcontrôleur permet de choisir une des deux actions à effectuer.

Lorsque, dans un premier cas, l'utilisateur a réalisé deux appuis rapides (b) et (c) d'une durée comprise entre 0 et 0,5 s chacun et séparés l'un de l'autre d'une durée minimale de 5s, le microcontrôleur, après avoir détecté ces deux appuis rapides, envoie l'ordre à la LED de produire un signal lumineux comportant une séquence de clignotement correspondant au dernier type de défaut ayant généré le déclenchement de l'appareil, l'information de ce type de défaut étant enregistrée dans le microcontrôleur. Après cela, le bouton poussoir redevient inactif (i).

Ainsi, tel qu'illustré sur la figure 4, lors de la détection de deux appuis courts (avec une durée d'appui court inférieure à 0,5 s et une durée entre ces deux appuis de 5s), une séquence de clignotement de la LED est lancée et pilotée par le microcontrôleur. Puis, le bouton poussoir redevient inactivé.

Dans le cas contraire ou l'utilisateur a réalisé un appui long en (d) sur le bouton poussoir d'une durée supérieure à 1 seconde, le microcontrôleur envoie une séquence de réalisation d'un test dit RCD en simulant un courant de défaut pendant environ 100ms, suffisant pour faire déclencher la protection RCD. Puis, le bouton poussoir redevient inactivé (i).

Selon une troisième possibilité, l'utilisateur exerce une pression (e) pendant une durée comprise entre 0,5s et 1 s, et dans ce cas, le bouton poussoir redevient inactivé.

Ainsi, selon cette réalisation, une activation longue du bouton poussoir d'une durée supérieure à 1 s envoie un test de protection contre les fuites à la terre en plaçant une résistance entre la phase et le neutre.

Deux activations courtes du bouton poussoir d'une durée inférieure à 0,5 s avec un intervalle de temps de 5 s entre deux activations envoient une séquence d'indication de la dernière information de déclenchement stockée dans la mémoire flash avec le code suivant :
- 1 clignotement : Aucune cause de déclenchement enregistrée, permet de vérifier le bon fonctionnement du produit.
- 2 clignotements : déclenchement suite à une fuite à la terre.
- 3 clignotements : déclenchement suite à la survenue d'un arc parallèle.
- 4 clignotements : déclenchement suite à la survenue d'un arc série.
- 5 clignotements : déclenchement suite à une surtension.
- 6 clignotements : déclenchement suite à un défaut interne.

La durée d'activation de la LED sera avantageusement de 100ms, tandis que la durée de non activité de la LED entre deux clignotements sera avantageusement de 1s.

Tel qu'illustré sur la figure 5, lors de la détection d'un appui long, on génère un courant différentiel normalisé entre la phase P et le neutre N dans le tore T afin de déclencher la protection RCD.

Dans cette réalisation particulière, la génération du courant différentiel passe par un transistor MOS S mais pourrait également passer par un thyristor 6 comme pour le circuit de déclenchement associé à la protection principale de l'appareil piloté par une sortie du microcontrôleur (RCD TEST).

Selon une autre réalisation d'un disjoncteur selon l'invention, celui-ci fonctionne tel qu'illustré sur la figure 3bis, ce mode de fonctionnement présentant une couverture de test plus importante. Ce mode de fonctionnement est le même que celui décrit sur la figure 3, à ceci près que, après un appui long détecté sur le bouton test, et le lancement d'une séquence de test de la fonction RCD, l'on réalise un test de la fonction détection d'arc et un auto-test du MCU avant l'injection d'un courant de test de la fonction RCD dans le capteur.

Sur les figures 6, 7,8 et 9, ont été représentés des chronogrammes illustrant le fonctionnement d'un disjoncteur selon un mode de réalisation particulier de l'invention dans lequel sont réalisées la fonction, dite seconde, d'envoi d'une séquence d'activation d'un circuit test RCD, et deux fonctions, dites troisièmes, respectivement d'envoi d'une séquence de la transmission d'information de la cause de déclenchement du disjoncteur pour l'une, et d'effacement de la mémoire interne, pour l'autre.

Tel qu'illustré sur la figure 6, la mise en oeuvre de la fonction dite seconde nécessite l'actionnement du bouton test par deux appuis courts successifs d'une durée maximale chacun de T1 dans une fenêtre temporelle de T6 (fenêtre temporelle dans laquelle les deux appuis courts doivent être réalisés pour lancer la séquence de transmission de l'information). Après cette séquence de deux appuis courts, la LED émet un clignotement d'une durée de T4 sur une période de T5 supérieure à T4.

Tel qu'illustré sur la figure 7, la mise en oeuvre de la fonction dite troisième, d'envoi de la séquence d'activation du circuit test nécessite un appui long sur le bouton d'une durée supérieure à T2. L'activation du circuit test de la protection différentielle est réalisée sur une durée T3, et l'on voit que cette activation débute pendant la durée de l'appui long, après la durée minimale requise T2 pour un appui long. La commande de l'actionneur destinée à entraîner le déclenchement de l'appareil débute au cours de la deuxième moitié de cette période T3.

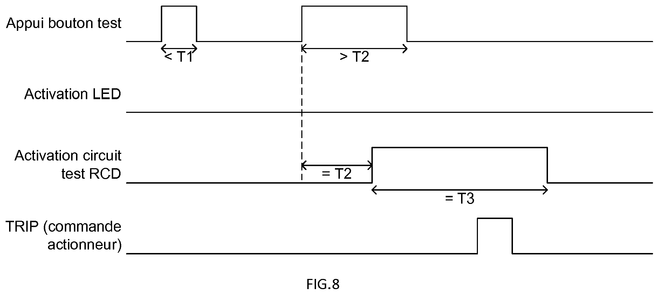

Tel qu'illustré sur la figure 8, la réalisation d'un appui court d'une durée inférieure à T1 suivie d'un appui long d'une durée supérieure à T2, entraîne l'activation du circuit test RCD après une période minimale de T2>T1 après le début de l'appui long précité, et un déclenchement du disjoncteur de la même manière que précédemment décrit en relation avec la figure 7.

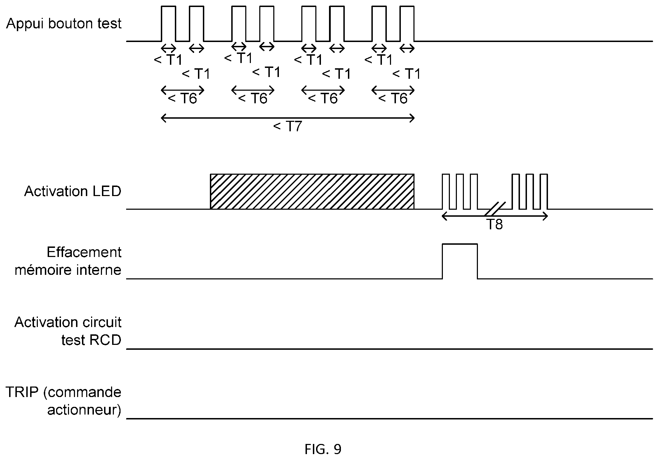

Tel qu'illustré sur la figure 9, l'appareil selon cette réalisation particulière réalise en outre la fonction, dite troisième, de RESET de la mémoire interne après la réalisation de quatre doubles appuis courts dans une fenêtre temporelle T7, fenêtre temporelle pendant laquelle ces quatre séquences de double appuis courts sont détectées pour lancer l'action particulière d'effacement de la zone mémoire dans laquelle est stockée l'historique des causes de déclenchement. Les deux appuis courts de chaque double appui doivent être réalisés dans une fenêtre temporelle T6. Lorsqu' un premier double appui est réalisé, la séquence de transmission de l'information par la LED est lancée. Chaque appui court aura une durée maximale de T1. Après la série de quatre séquences de doubles appuis réalisés dans la fenêtre temporelle minimale de T7, un ordre d'effacement de la mémoire interne est envoyé et une séquence de clignotements rapides de la LED est activée pour signifier à l'utilisateur, à l'arrêt de ce clignotement, que la mémoire interne est effacée à l'issue d'une durée T8.

On notera que toutes les valeurs numériques de durée données dans ce qui précède, ne sont données qu'à titre indicatif, à titre d'exemple.

On notera qu'avantageusement, la LED peut être activée entre les deux appuis courts afin que l'utilisateur ait une remontée de l'état du produit.

On notera qu'au lieu de faire clignoter une LED 7, on pourrait lancer la transmission de l'information via une liaison sans fils. L'appareil de protection électrique selon l'invention pourrait également comporter des moyens pour permettre à l'utilisateur d'acquitter l'action demandée. Ainsi, par exemple, une fois que le microcontrôleur MCU a détecté une action (2 pressions courtes ou bien 1 pression longue), la LED clignote pendant une durée déterminée suivant deux clignotements différents selon ce que le microcontrôleur MCU a détecté, et pendant ce clignotement de la LED, l'utilisateur doit appuyer une fois sur le bouton poussoir PTT pour confirmer que l'action correspond à ce qu'il souhaite.

Cette mutualisation de l'action sur le bouton test peut être étendue à d'autres actions que la transmission de la dernière cause de déclenchement, comme par exemple faire un test de la protection VIGI sans TRIP. Ainsi, deux appuis courts lanceraient une action de test sans TRIP, tandis qu'un appui long lancerait un test avec TRIP.

Ou encore, sur un appareil RCD type B, deux appuis courts lanceraient un test classe AC, tandis qu'un appui long lancerait un test de la détection d'un défaut différentiel sur courant continu, etc....

L'invention s'applique à tout appareil de protection électrique équipé d'un bouton test et d'une intelligence de décodage (microcontrôleur) dans lequel on veut ajouter une fonction sur demande ayant une valeur ajoutée pour l'utilisateur. On notera qu'une carte électronique simple avec un micro le plus petit possible peut aussi être ajoutée afin d'enrichir les fonctionnalités à faible coût des produits existants.

Bien entendu, l'invention n'est pas limitée aux modes de réalisation décrits et illustrés qui n'ont été donnés qu'à titre d'exemple.

## Revendications

1. Appareil de protection électrique comportant au moins une fonction électrique de protection dite première ou principale apte à être réalisée par un microcontrôleur et un bouton dit bouton test destiné à être actionné par un utilisateur pour entraîner la mise en oeuvre du test d'au moins une fonction électrique dite seconde, cette mise en oeuvre du test étant destinée à entraîner le déclenchement de l'appareil de protection, des moyens pour mutualiser l'actionnement de ce bouton test (3 ou PTT) avec au moins une action destinée à réaliser une fonction dite troisième, en fonction de différents types d'action exercées sur le bouton test, ces actions étant détectées par le microcontrôleur (MCU) dans le but pour ce dernier de donner l'ordre de réaliser l'une des fonctions dites troisièmes précitées ou bien le test de l'une des fonctions dites secondes précitées, la fonction électrique dite première ou principale comprenant la fonction de détection d'un court-circuit ou bien la fonction de détection d'une surcharge électrique, **caractérisé en ce que** la au moins une fonction dite seconde est l'une des fonctions comprises dans le groupe comprenant une fonction de protection différentielle, une fonction de détection d'arc, ou une fonction de détection d'un défaut différentiel sur courant continu, et **en ce que** la au moins une fonction dite troisième est la fonction de transmission de l'information de la dernière cause du déclenchement de l'appareil, laquelle information étant stockée par le microcontrôleur (MCU).

2. Appareil de protection électrique selon la revendication 1, **caractérisé en ce que** l'appareil comportant la fonction protection différentielle, l'information précitée est la valeur du courant de fuite à la terre vu par la protection différentielle.

3. Appareil de protection électrique selon la revendication 1 ou 2, **caractérisé en ce que** les moyens de transmission de l'information précitée, dits premiers, comportent une LED dite première (7), ou bien une liaison sans fil.

4. Appareil de protection électrique selon la revendication 3, **caractérisé en ce que** la LED précitée est apte à émettre un signal lumineux codé dont le code correspond au type d'information à transmettre.

5. Appareil de protection électrique selon la revendication 1, **caractérisé en ce que** la dernière cause du déclenchement est l'une des causes comprises dans le groupe comprenant la détection d'un défaut différentiel, la détection d'un arc série, la détection d'un arc parallèle, la détection d'un défaut du à une surtension ou d'un défaut d'origine interne à l'appareil.

6. Appareil de protection électrique selon l'une quelconque des revendications précédentes, **caractérisé en ce que** les différents types d'action sur le bouton test (3 ou PTT) comprennent un appui long et/ou un appui court et/ou un double appui court et/ou un nombre donné, ou une combinaison, des séquences précédentes dans une fenêtre temporelle donnée.

7. Appareil de protection électrique selon la revendication 6, **caractérisé en ce que** l'actionnement du bouton test (3 ou PTT) par un appui long a pour effet l'envoi par le microcontrôleur d'un ordre de réalisation du test de l'une des fonctions dites secondes pendant un temps calibré, tandis que l'actionnement du bouton test par un double appui court a pour effet la réalisation d'au moins l'une des fonctions dites troisièmes précitées.

8. Appareil de protection électrique selon la revendication 6, **caractérisé en ce que** l'actionnement du bouton test par un nombre donné de doubles appuis courts dans une fenêtre temporelle donnée envoie une séquence de RESET dans la mémoire interne.

9. Appareil de protection électrique selon l'une quelconque des revendications précédentes, **caractérisé en ce qu'**il comporte des moyens d'information de l'utilisateur, dits seconds, du type d'action exercée sur le bouton test (3 ou PTT) détectée par le microcontrôleur (MCU), et des moyens d'acquittement par l'utilisateur de l'action demandée au moyen d'un nouvel actionnement du bouton test.

10. Appareil de protection électrique selon la revendication 9, **caractérisé en ce que** les moyens d'information dits seconds comportent une LED, dite seconde, apte à clignoter après l'actionnement du bouton test (3 ou PTT) pendant une durée prédéterminée suivant deux clignotements différents en fonction de ce que le microcontrôleur (MCU) a détecté, ce clignotement étant apte à être interrompu pendant cette durée lorsque l'utilisateur actionne les moyens d'acquittement précités.

11. Appareil de protection électrique selon la revendication 3 ou 10, **caractérisé en ce que** la LED dite première et/ou la LED dite seconde est située sur la face avant de l'appareil.

12. Appareil de protection électrique selon l'une quelconque des revendications précédentes, **caractérisé en ce que** c'est un disjoncteur différentiel (D) comportant la fonction de détection d'arc.

13. Appareil de protection électrique selon la revendication 11, **caractérisé en ce qu'**il comporte un module disjoncteur (1) associé à un module de protection différentielle (2) intégrant la fonction de détection d'arc.

## Patentansprüche

1. Elektrischer Schutzschalter, umfassend mindestens eine so genannte erste elektrische Schutzfunktion oder elektrische Hauptschutzfunktion, die geeignet ist, von einem Mikrokontroller und einer so genannten Prüftaste eingesetzt zu werden, die dazu bestimmt ist, von einem Benutzer betätigt zu werden, um den Einsatz der Prüfung mindestens einer so genannten elektrischen Hilfsfunktion zu bewirken, wobei dieser Einsatz der Prüfung dazu bestimmt ist, das Auslösen des elektrischen Schutzschalters zu bewirken, Mittel, um die Betätigung dieser Prüftaste (3 oder PTT) mit mindestens einer Aktion zusammenzulegen, die dazu bestimmt ist, eine so genannte dritte Funktion in Abhängigkeit von verschiedenen auf die Prüftaste ausgeübten Aktionstypen zu verwirklichen, wobei diese Aktionen vom Mikrokontroller (MCU) erfasst werden, so dass dieser letztgenannte den Befehl zur Durchführung einer der vorgenannten dritten Funktionen oder auch die Prüfung einer der vorgenannten so genannten Hilfsfunktionen vorgibt, wobei die so genannte erste elektrische Funktion oder elektrische Hauptfunktion die Funktion der Erfassung eines Kurzschlusses oder auch die Funktion der Erfassung einer elektrischen Überlast umfasst, **dadurch gekennzeichnet, dass** die mindestens eine so genannte Hilfsfunktion eine der Funktionen ist, die in der Gruppe enthalten sind, umfassend eine Differentialschutzfunktion, eine Lichtbogenerfassungsfunktion oder eine Erfassungsfunktion eines Differentialfehlers am Gleichstrom, und dass die mindestens eine so genannte dritte Funktion die Funktion der Übertragung der Information der letzten Ursache für die Auslösung des Schalters ist, wobei die Information vom Mikrokontroller (MCU) gespeichert ist.

2. Elektrischer Schutzschalter nach Anspruch 1, **dadurch gekennzeichnet, dass**, wobei der Schalter die Differentialschutzfunktion umfasst, die vorgenannte Information der Wert des Leckagestroms an der Erde vom Differentialschutz aus gesehen ist.

3. Elektrischer Schutzschalter nach Anspruch 1 oder 2, **dadurch gekennzeichnet, dass** die Übertragungsmittel der vorgenannten Information, erste Mittel genannt, eine so genannte erste LED (7) oder auch eine drahtlose Verbindung umfassen.

4. Elektrischer Schutzschalter nach Anspruch 3, **dadurch gekennzeichnet, dass** die vorgenannte LED geeignet ist, ein codiertes Lichtsignal zu senden, dessen Code dem zu übertragenden Informationstyp entspricht.

5. Elektrischer Schutzschalter nach Anspruch 1, **dadurch gekennzeichnet, dass** die letzte Ursache für die Auslösung eine der Ursachen ist, die in der Gruppe enthalten ist, umfassend die Erfassung eines Differentialfehlers, die Erfassung eines seriellen Lichtbogens, die Erfassung eines parallelen Lichtbogens, die Erfassung eines Fehlers auf Grund einer Überspannung oder eines Fehlers internen Ursprungs im Schalter.

6. Elektrischer Schutzschalter nach einem der vorhergehenden Ansprüche, **dadurch gekennzeichnet, dass** die verschiedenen Aktionstypen auf die Prüftaste (3 oder PTT) ein langes Drücken und/oder ein kurzes Drücken und/oder ein zweimaliges Drücken und/oder eine gegebene Anzahl oder eine Kombination der vorhergehenden Sequenzen in einem gegebenen Zeitfenster umfassen.

7. Elektrischer Schutzschalter nach Anspruch 6, **dadurch gekennzeichnet, dass** die Betätigung der Prüftaste (3 oder PTT) durch langes Drücken das Senden eines Befehls zur Durchführung einer Prüfung einer der so genannten Hilfsfunktionen während einer geeichten Zeit durch den Mikrokontroller bewirkt, während die Betätigung der Prüftaste durch ein zweimaliges kurzes Drücken die Durchführung mindestens einer der vorgenannten so genannten dritten Funktionen bewirkt.

8. Elektrischer Schutzschalter nach Anspruch 6, **dadurch gekennzeichnet, dass** die Betätigung der Prüftaste durch eine gegebene Anzahl von zweimaligem kurzem Drücken in einem gegebenen Zeitfenster eine RESET-Sequenz in den internen Speicher sendet.

9. Elektrischer Schutzschalter nach einem der vorhergehenden Ansprüche, **dadurch gekennzeichnet, dass** der Mittel zur Information des Benutzers, Hilfsmittel genannt, umfasst, vom Typ einer Aktion auf die Prüftaste (3 oder PTT), die vom Mikrokontroller (MCU) erfasst wird, und Mittel zum Quittieren der geforderten Aktion durch den Benutzer mit Hilfe einer neuerlichen Betätigung der Prüftaste.

10. Elektrischer Schutzschalter nach Anspruch 9, **dadurch gekennzeichnet, dass** die Informationsmittel, Hilfsmittel genannt, eine so genannte zweite LED, umfassen, die geeignet ist, nach der Betätigung der Prüftaste (3 oder PTT) während einer vorbestimmten Dauer mit zwei unterschiedlichen Blinkzeichen zu blinken, in Abhängigkeit davon, was der Mikrokontroller (MCU) erfasst hat, wobei dieses Blinken geeignet ist, während dieser Dauer unterbrochen zu werden, wenn der Benutzer die vorgenannten Quittierungsmittel betätigt.

11. Elektrischer Schutzschalter nach Anspruch 3 oder 10, **dadurch gekennzeichnet, dass** die so genannte erste LED und/oder die so genannte zweite LED auf der Vorderseite des Schalters angeordnet ist.

12. Elektrischer Schutzschalter nach einem der vorhergehenden Ansprüche, **dadurch gekennzeichnet, dass** ein Differentialschalter (D) die Lichtbogenerfassungsfunktion umfasst.

13. Elektrischer Schutzschalter 11, **dadurch gekennzeichnet, dass** er ein Abschaltmodul (1) umfasst, das einem Differentialschutzmodul (2) zugeordnet ist, das die Lichtbogenerfassungsfunktion integriert.

## Claims

1. Electrical protection apparatus comprising at least one so-called first or main electrical protection function able to be carried out by a microcontroller and a button termed a test button intended to be actuated by a user to give rise to the implementation of the testing of at least one so-called second electrical function, this implementation of the test being intended to give rise to the tripping of the protection apparatus, means for pooling the actuation of this test button (3 or PTT) with at least one action intended to carry out a so-called third function, as a function of various types of action exerted on the test button, these actions being detected by the microcontroller (MCU), the aim being for the latter to give the order to carry out one of the aforementioned so-called third functions or else the testing of one of the aforementioned so-called second functions, the so-called first or main electrical function comprising the short-circuit detection function or else the electrical overload detection function, **characterized in that** the at least one so-called second function is one of the functions contained in the group comprising a differential protection function, an arc detection function, or a DC differential fault detection function, and **in that** the at least one so-called third function is the function of transmission of the item of information on the last trip cause of the apparatus, said item of information being stored by the microcontroller (MCU).

2. Electrical protection apparatus according to Claim 1, **characterized in that**, the apparatus comprising the differential protection function, the aforementioned item of information is the value of the earth leakage current seen by the differential protection.

3. Electrical protection apparatus according to Claim 1 or 2, **characterized in that** the so-called first means for transmitting the aforementioned item of information comprise a so-called first LED (7), or else a wireless link.

4. Electrical protection apparatus according to Claim 3, **characterized in that** the aforementioned LED is able to emit an encoded luminous signal, the code of which corresponds to the type of item of information to be transmitted.

5. Electrical protection apparatus according to Claim 1, **characterized in that** the last trip cause is one of the causes contained in the group comprising the detection of a differential fault, the detection of a series arc, the detection of a parallel arc, the detection of a fault due to an overvoltage or of a fault originating internally from the apparatus.

6. Electrical protection apparatus according to any one of the preceding claims, **characterized in that** the various types of action on the test button (3 or PTT) comprise a long press and/or a short press and/or a double short press, and/or a given number, or a combination, of the previous sequences within a given temporal window.

7. Electrical protection apparatus according to Claim 6, **characterized in that** the actuation of the test button (3 or PTT) by a long press has the effect of sending, by the microcontroller, of an order to carry out the testing of one of the so-called second functions for a calibrated time, whereas the actuation of the test button by a double short press has the effect of carrying out at least one of the aforementioned so-called third functions.

8. Electrical protection apparatus according to Claim 6, **characterized in that** the actuation of the test button by a given number of short double presses within a given temporal window sends a RESET sequence to the internal memory.

9. Electrical protection apparatus according to any one of the preceding claims, **characterized in that** it comprises so-called second means for informing the user of the type of action exerted on the test button (3 or PTT) and detected by the microcontroller (MCU), and means for the user to acknowledge the requested action by way of a new actuation of the test button.

10. Electrical protection apparatus according to Claim 9, **characterized in that** the so-called second information means comprise a so-called second LED able to flash after the actuation of the test button (3 or PTT) for a predetermined duration with two different flashes depending on what the microcontroller (MCU) has detected, this flashing being able to be interrupted during this duration when the user actuates the aforementioned acknowledgement means.

11. Electrical protection apparatus according to Claim 3 or 10, **characterized in that** the so-called first LED and/or the so-called second LED is situated on the front face of the apparatus.

12. Electrical protection apparatus according to any one of the preceding claims, **characterized in that** it is a differential circuit breaker (D) comprising the arc detection function.

13. Electrical protection apparatus according to Claim 11, **characterized in that** it comprises a circuit breaker module (1) associated with a differential protection module (2) incorporating the arc detection function.
